# DEMANDE DE BREVET EUROPEEN

(11) **EP 3 879 773 A1**
(43) Date de publication de la demande: **15.09.2021**
(21) Numéro de dépôt: 21159022.9
(22) Date de dépôt: 24.02.2021
(51) Int. Cl.: H04L 27/06, H03K 5/19, H04L 7/08

(54) **PROCÉDÉ ET DISPOSITIF DE DÉTECTION DE LA PRÉSENCE ÉVENTUELLE D AU MOINS UN MOTIF NUMÉRIQUE AU SEIN D'UN SIGNAL**

(30) Priorité: 09.03.2020 FR 2002311
(71) Demandeur: STMicroelectronics (Rousset) SAS, 13790 Rousset (FR)
(72) Inventeur: BOUVET, Yoann, 06650 OPIO (FR)
(74) Mandataire: Casalonga

(57) **Abrégé**

On utilise autant de moyens de mémoire adressables circulairement (MMA, MMB, MMC) qu'il y a de motifs numériques modulants possibles et ayant des tailles respectives correspondant à celles des motifs. Ces tailles sont premières entre elles. On adresse ces moyens de mémoire, de façon circulaire, au rythme d'un signal de cadencement ayant la fréquence de modulation.

On extrait au rythme de ce signal de cadencement des valeurs indicatives de l'intensité du signal (VRSSIk). On stocke chaque valeur extraite en parallèle dans les emplacements mémoire adressés des moyens de mémoire, en cumulant cette valeur avec le contenu de l'emplacement mémoire correspondant, et on répète ces opérations pendant une durée d'acquisition bien supérieure à la durée nécessaire pour adresser en totalité le moyen de mémoire le plus grand. Une analyse des contenus des emplacements-mémoire des moyens de mémoire permet de détecter la présence éventuelle d'un motif au sein du signal.

## Description

Des modes de mise en œuvre de l'invention concernent le traitement de signaux modulés, par exemple par une modulation du type tout ou rien, connue par l'homme du métier sous l'acronyme OOK (« On Off Keying »), et notamment la détection de la présence éventuelle au sein de ces signaux, d'un ou de plusieurs motifs numériques modulant ces signaux.

Une application particulièrement intéressante de l'invention concerne l'analyse d'un signal de balise (« beacon signal ») reçu par un objet connecté d'un réseau d'objets connectés déployé par l'opérateur de télécommunication Sigfox, de façon à déterminer la configuration radio Sigfox (Sigfox RC : Sigfox Radio Configuration) applicable à cet objet connecté. Cette configuration radio correspond en pratique à une région géographique.

Le réseau Sigfox d'objets connectés, bien connu de l'homme du métier, est un réseau mondial à bande étroite avec un faible débit de données et une longue portée permettant à des objets, per exemple de simples capteurs, de communiquer avec un émetteur ou station de base.

La bande de fréquences se situe dans le domaine subgigaHertz.

Avant qu'un objet puisse dialoguer avec une station de base, il doit savoir dans quelle région il fonctionne.

Pour cela, l'objet doit, préalablement à tout dialogue avec une station de base, recevoir et analyser un signal de balise émis par la station de base, car c'est ce signal de balise qui va indiquer à l'objet dans quelle région il se trouve et donc dans quelle région il va devoir fonctionner.

Ce signal de balise envoyé par le réseau Sigfox est appelé signal « Monarch ».

Le signal de balise « Monarch » est émis à la fréquence RF définie par la région dans laquelle l'émetteur est situé.

Ce signal de balise est une porteuse modulée, par une modulation en tout ou rien, par une succession de deux motifs numériques répétitifs.

Ces deux motifs sont choisis dans un groupe de plusieurs motifs différents, typiquement trois.

La fréquence porteuse, encore appelée fréquence centrale, fait partie d'une liste de fréquences centrales « Monarch » possibles.

La fréquence centrale ainsi que les deux motifs définissent ladite configuration radio ou région dans laquelle se situe la station de base.

Un objet balaye toutes les fréquences centrales « Monarch » possibles pour rechercher le premier motif. Une fois qu'il trouve le premier motif à la bonne fréquence centrale, il recherchera le deuxième motif à cette même fréquence centrale.

Une fois qu'il a trouvé le deuxième motif, l'objet connaît donc la fréquence centrale (fréquence porteuse) et les deux motifs, et par conséquent il sait dans quelle région il se trouve.

Comme indiqué ci-avant, le signal de balise « Monarch » est modulé par une modulation du type OOK.

Par conséquent un objet connecté ne comportant pas de démodulateur OOK ne peut pas actuellement démoduler le signal et donc détecter les motifs numériques contenus dans le signal.

Or implémenter un démodulateur OOK présente des inconvénients, par exemple en termes de complexité et/ou d'encombrement surfacique, qui peuvent s'avérer difficilement conciliables dans certaines applications, par exemple avec des architectures simples de simples capteurs.

Il existe donc un besoin de pouvoir détecter un ou plusieurs motifs numériques modulant une porteuse par une modulation OOK, par exemple mais non limitativement un signal de balise du réseau Sigfox, sans utiliser de démodulateur OOK.

A cet égard l'inventeur a observé que les nombres d'échantillons des motifs numériques modulants du signal de balise Sigfox, sont des entiers premiers entre eux.

A partir de cette observation, il est proposé selon un mode de mise en œuvre et de réalisation,
- d'utiliser autant de moyens de mémoire adressables circulairement qu'il y a de motifs numériques modulants possibles et ayant des tailles respectives correspondant à celles des motifs,
- d'adresser ces moyens de mémoire, de façon circulaire, au rythme d'un signal de cadencement ayant la fréquence de modulation,
- d'extraire au rythme de ce signal de cadencement des valeurs indicatives de l'intensité du signal (valeurs RSSI : Received Signal Strength Intensity),
- de stocker chaque valeur extraite en parallèle dans les emplacements mémoire adressés des moyens de mémoire, en cumulant cette valeur avec le contenu de l'emplacement mémoire correspondant, et
- de répéter ces opérations pendant une durée d'acquisition bien supérieure à la durée nécessaire pour adresser en totalité le moyen de mémoire le plus grand.

Chaque motif ayant un seul échantillon, par exemple un bit égal à 1, modulant « en tout » ladite porteuse (les autres échantillons, par exemples des bits égaux à 0, modulant « en rien » ladite porteuse), seul le moyen de mémoire ayant une taille correspondant à celle du motif effectivement présent dans le signal lors de ladite durée d'acquisition, verra un seul et même emplacement mémoire recevoir toujours, au cours de la durée d'acquisition, la valeur d'intensité correspondant au bit égal à 1 et donc présenter une valeur cumulée « pic » (correspondant à du signal), les autres emplacements mémoire ne stockant que du bruit.

Quant aux autres moyens de mémoire, aucun de leurs emplacements mémoire ne présentera de pic par rapport aux autres car la valeur d'intensité correspondant au bit égal à 1 se répartira de façon quasi uniforme sur tous les emplacements mémoire pendant ladite durée d'acquisition.

Une analyse des contenus des emplacements mémoire des moyens de mémoire permet alors de déterminer le moyen de mémoire présentant le pic de signal et donc d'en déduire quel est le motif présent dans le signal reçu.

Par ailleurs à la différence d'un démodulateur OOK qui délivrerait les valeurs logiques effectives 0 ou 1 des bits reçus du motif (« hard bits ») pour prendre ensuite la décision sur la nature du motif reçu, il est proposé ici d'utiliser simplement des valeurs RRSI (« soft bits »), incluant du signal et du bruit, en combinaison avec l'adressage circulaire des moyens de mémoire, pour prendre ensuite la décision sur la nature du motif reçu.

Ainsi selon un aspect, il est proposé un procédé de détection de la présence éventuelle d'au moins un motif numérique au sein d'un signal.

Ledit au moins un motif appartient à un groupe de J motifs de référence, J étant supérieur ou égal à 2, comportant respectivement Nj échantillons séquencés à une fréquence F, Nj étant un entier différent pour chaque motif de référence, et les J entiers Nj étant premiers entre eux.

Ledit signal est issu d'une porteuse modulée par les Nj échantillons dudit au moins un motif numérique par une modulation en tout ou rien (modulation de type OOK) à la fréquence F pendant une durée de modulation au cours de laquelle le motif se répète à une fréquence égale à F/Nj.

Chaque motif de référence a un seul échantillon logique, par exemple un bit égal à 1, autorisant l'émission de la porteuse et Nj-1 échantillons logiques, par exemple des bits nuls, inhibant l'émission de ladite porteuse.

Le procédé selon cet aspect comprend une réception du signal et un traitement du signal reçu.

Le traitement comprend :
a) à la fréquence F et pendant une durée d'acquisition,
   des adressages successifs et de façon circulaire des emplacements-mémoire de J moyens de mémoire ayant respectivement Nj emplacements-mémoire, et
   des stockages accumulatifs successifs de valeurs indicatives de l'intensité du signal, en parallèle dans les J emplacements mémoires adressés des J moyens de mémoire, et
b) une détection de la présence éventuelle dudit au moins un motif comportant une analyse des valeurs cumulées contenues dans les emplacements mémoire des J moyens de mémoire.

Lorsque le signal reçu contient effectivement un motif, par exemple lorsqu'on analyse le signal reçu dans une fenêtre temporelle dans laquelle le motif est présent, il pourrait suffire de repérer l'emplacement mémoire du moyen de mémoire contenant la valeur cumulée la plus grande pour en déduire quel est le motif émis parmi les motifs de référence possibles.

Cela étant dans certaines applications, le ou les motifs peuvent n'être émis que dans des fenêtres temporelles périodiques et à des instants aléatoires.

C'est le cas par exemple pour le signal balise du réseau Sigfox, qui a une longueur de 400 ms et qui est émis à un instant temporellement aléatoire au cours d'une fenêtre de 10 secondes se répétant toutes les cinq minutes.

Aussi en fonction des instants, l'analyse du signal conduit à la détection d'une absence de motif dans le signal reçu car en fait on ne reçoit que du bruit.

Aussi afin de minimiser voire de supprimer le risque de détection de « faux positifs », il est avantageusement prévu de prendre en compte un rapport signal sur bruit.

Plus précisément, selon un mode de mise en œuvre, ladite analyse des valeurs cumulées comporte pour chacun des J moyens de mémoire, une détermination de l'emplacement-mémoire dont la valeur cumulée est la plus grande, une détermination d'une moyenne des valeurs cumulées contenues dans les autres emplacements-mémoire, une différence entre une valeur tirée de ladite valeur cumulée la plus grande et ladite moyenne, et une comparaison de ladite différence à un seuil.

Afin de prévoir un unique seuil pour chacun des moyens de mémoire, il est avantageux d'utiliser pour faire ladite différence,
- la valeur cumulée la plus grande, normalisée par le nombre de fois où le moyen de mémoire correspondant a été totalement adressé, et
- la moyenne desdites valeurs cumulées contenues dans les autres emplacements-mémoire, normalisée par le nombre de fois où le moyen de mémoire correspondant a été totalement adressé.

Une obtention de chacune des J différences inférieure au seuil correspondant, est alors représentative de l'absence de tout motif dans le signal.

Une obtention de l'une des J différences supérieure au seuil correspondant est alors représentative de la présence dans le signal du motif ayant le nombre d'échantillons égal au nombre d'emplacements mémoire du moyen de mémoire pour lequel ladite différence supérieure au seuil a été obtenue.

De façon à obtenir une détection suffisamment fiable, la durée d'acquisition est choisie au moins 10 fois plus grande que la durée du motif de référence ayant le plus grand nombre d'échantillons.

Ainsi par exemple pour le signal de balise « Monarch », on pourra prendre par exemple une durée d'acquisition de 19 ms.

La porteuse est par exemple un signal périodique, par exemple de forme sinusoïdale, ayant une fréquence porteuse.

Ledit traitement comprend alors en outre, selon un mode de mise en œuvre, préalablement aux étapes a) et b),
c) une transposition du signal reçu en bande de base sur deux voies en quadrature de phase à l'aide de la fréquence porteuse, et
d) une conversion analogique numérique des deux signaux en quadrature de phase de façon à obtenir deux signaux numériques en bande de base, et
   l'étape a) comprend une détermination desdites valeurs indicatives de l'intensité du signal à partir desdits signaux numériques en bande de base.

Dans certaines applications, comme par exemple dans le réseau Sigfox, J est supérieur à deux, par exemple égal à trois. En d'autres termes le motif peut être choisi parmi plus que deux motifs de référence.

Que J soit supérieur à 2 ou égal à 2, ledit signal peut, selon un mode de mise en œuvre applicable en particulier au réseau Sigfox, être issu de la porteuse modulée par une modulation en tout ou rien par un premier motif numérique appartenant au groupe de J motifs de référence pendant une première durée de modulation puis par un deuxième motif numérique appartenant au groupe de J motifs de référence pendant une deuxième durée de modulation.

Et après avoir détecté la présence du premier motif, on met en œuvre ledit traitement pour détecter la présence éventuelle du deuxième motif.

Bien entendu même si en pratique le premier motif et le deuxième motif sont différents, ils pourraient être en théoriquement identiques.

Dans certaines applications, la fréquence de la porteuse pourrait être unique et fixée.

Cela étant, dans d'autres applications possibles, comme par exemple dans le réseau Sigfox, la fréquence porteuse peut appartenir à un ensemble de fréquences différentes.

Le traitement comporte alors avantageusement une mise en œuvre des étapes a), b), c) et d) pour chacune des fréquences différentes de façon à détecter la présence dudit au moins un motif et la fréquence de la porteuse.

Dans certaines situations, par exemple lorsque deux fréquences porteuses possibles sont proches l'une de l'autre, il est possible d'obtenir plusieurs différences (entre les valeurs cumulées normalisées les plus grandes et les moyennes normalisées) supérieures aux seuils correspondants.

Dans un tel cas, on sélectionne la plus grande pour désigner ledit au moins un motif.

Selon un mode de mise en œuvre, après avoir détecté la présence du premier motif et la fréquence de la porteuse, le traitement de la détection de la présence éventuelle du deuxième motif comprend la mise en œuvre de l'étape c) avec la fréquence de la porteuse déterminée lors de la détection du premier motif.

Selon un mode de mise en œuvre particulier, applicable par exemple au signal de balise « Monarch » utilisé dans le réseau d'objets connectés déployé par l'opérateur de télécommunication Sigfox, J est égal à 3 et les trois entiers Nj sont respectivement égaux à 11, 13 et 16.

Selon un autre aspect, il est proposé un dispositif de détection de la présence éventuelle d'au moins un motif numérique au sein d'un signal, ledit au moins un motif appartenant à un groupe de J motifs de référence, J étant supérieur ou égal à 2, comportant respectivement Nj échantillons séquencés à une fréquence F, Nj étant un entier différent pour chaque motif de référence, et les J entiers Nj étant premiers entre eux, ledit signal étant issu d'une porteuse modulée par les Nj échantillons dudit au moins un motif numérique par une modulation en tout ou rien à la fréquence F pendant une durée de modulation au cours de laquelle le motif se répète à une fréquence égale à F/Nj, chaque motif de référence ayant un seul échantillon autorisant l'émission de la porteuse et Nj-1 échantillons logiques inhibant l'émission de ladite porteuse.

Le dispositif selon cet aspect comprend une interface d'entrée configurée pour recevoir le signal, J moyens de mémoire ayant respectivement Nj emplacements-mémoire, et des moyens de traitement comportant :
- des moyens d'accumulation configurés pour effectuer à la fréquence F et pendant une durée d'acquisition, des adressages successifs et de façon circulaire des emplacements-mémoire des J moyens de mémoire, et des stockages accumulatifs successifs de valeurs indicatives de l'intensité du signal, en parallèle dans les J emplacements mémoires adressés des J moyens de mémoire, et
- des moyens de détection configurés pour effectuer une détection de la présence éventuelle dudit au moins un motif et comportant des moyens d'analyse configurés pour effectuer une analyse des valeurs cumulées contenues dans les emplacements mémoire des J moyens de mémoire.

Selon un mode de réalisation, les moyens d'analyse sont configurés pour effectuer, pour chacun des J moyens de mémoire, une détermination de l'emplacement-mémoire dont la valeur cumulée est la plus grande, une détermination d'une moyenne des valeurs cumulées contenues dans les autres emplacements-mémoire, une différence entre une valeur tirée de ladite valeur cumulée la plus grande et ladite moyenne, et une comparaison de ladite différence à un seuil.

Selon un mode de réalisation, ladite valeur est la valeur cumulée la plus grande normalisée par le nombre de fois où le moyen de mémoire correspondant a été totalement adressé, et ladite moyenne est la moyenne desdites valeurs cumulées normalisée par le nombre de fois où le moyen de mémoire correspondant a été totalement adressé.

Selon un mode de réalisation, une obtention de chacune des J différences inférieure au seuil correspondant, est représentative de l'absence de tout motif dans le signal.

Selon un mode de réalisation, une obtention de l'une des J différences supérieure au seuil correspondant est représentative de la présence dans le signal du motif ayant le nombre d'échantillons égal au nombre d'emplacements mémoire du moyen de mémoire pour lequel ladite différence supérieure au seuil a été obtenue.

Selon un mode de réalisation, la durée d'acquisition est au moins 10 fois plus grande que la durée du motif de référence ayant le plus grand nombre d'échantillons.

Selon un mode de réalisation, la porteuse est un signal périodique ayant une fréquence porteuse, et les moyens de traitement comprennent
- des moyens de transposition configurés pour effectuer une transposition du signal reçu en bande de base sur deux voies en quadrature de phase à l'aide de la fréquence porteuse, et
- un étage de conversion configuré pour effectuer une conversion analogique numérique des deux signaux en quadrature de phase de façon à obtenir deux signaux numériques en bande de base, et
- les moyens d'analyse sont configurés pour effectuer une détermination desdites valeurs indicatives de l'intensité du signal à partir desdits signaux numériques en bande de base.

Selon un mode de réalisation,
- ledit signal est issu de la porteuse modulée par une modulation en tout ou rien par un premier motif numérique appartenant au groupe de J motifs de référence pendant une première durée de modulation puis par un deuxième motif numérique appartenant au groupe de J motifs de référence pendant une deuxième durée de modulation, et
- le dispositif comprend en outre des moyens de commande configurés pour, après détection de la présence du premier motif, activer les moyens de traitement pour détecter la présence éventuelle du deuxième motif.

Selon un mode de réalisation, la fréquence porteuse appartient à un ensemble de fréquences différentes, et les moyens de commande sont configurés pour activer les moyens de traitement pour chacune des fréquences différentes de façon à détecter la présence dudit au moins un motif et la fréquence de la porteuse.

Selon un mode de réalisation, en cas d'obtention de plusieurs différences supérieures aux seuils correspondants, les moyens de détection comprennent des moyens de sélection configurés pour sélectionner la plus grande pour désigner ledit au moins un motif.

Selon un mode de réalisation, après avoir détecté la présence du premier motif et la fréquence de la porteuse, les moyens de commande sont configurés pour activer les moyens de traitement pour ladite fréquence porteuse de façon à détecter la présence éventuelle du deuxième motif.

Selon un mode de réalisation, J est égal à 3 et les trois entiers Nj sont respectivement égaux à 11, 13 et 16.

Ledit signal est par exemple un signal de balise utilisé dans le réseau d'objets connectés déployé par l'opérateur de télécommunication Sigfox.

Selon un autre aspect, il est proposé un objet connecté incorporant un dispositif tel que défini ci-avant.

D'autres avantages et caractéristiques de l'invention apparaîtront à l'examen de la description détaillée de modes de réalisation et de mise en œuvre, nullement limitatifs, et des dessins annexés sur lesquels :
[Fig 1]
[Fig 2]
[Fig 3]
[Fig 4]
[Fig 5]
[Fig 6]
[Fig 7] et
[Fig 8] illustrent schématiquement des modes de réalisation et de mise en œuvre de l'invention.

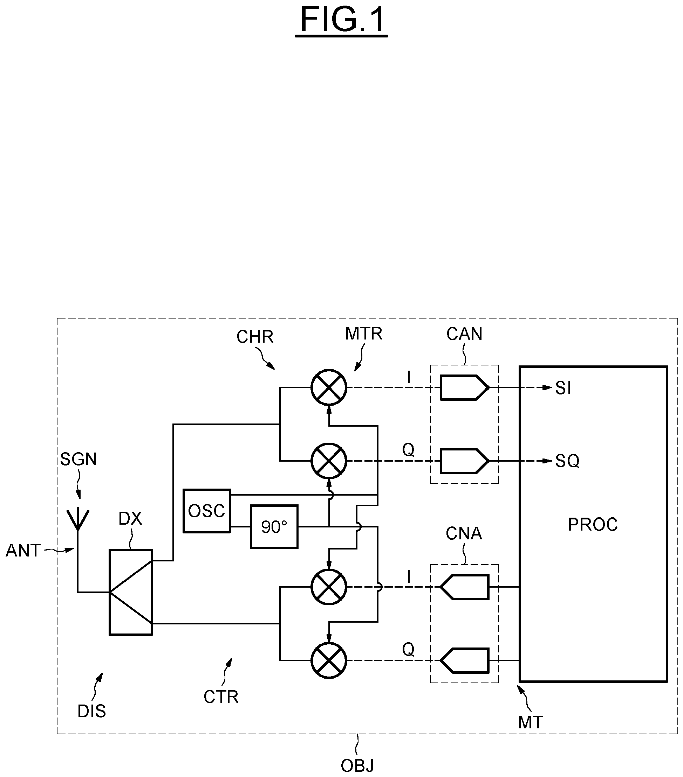

Sur la figure 1, la référence OBJ désigne un objet connecté, par exemple une valise, appartenant à un réseau d'objets connectés, par exemple mais non limitativement le réseau d'objets connectés déployé par l'opérateur de télécommunication Sigfox.

Cet objet incorpore un dispositif DIS de détection de la présence éventuelle d'au moins un motif numérique au sein d'un signal SGN émis par exemple un signal de balise, tel que le signal de balise « Monarch » émis par une station de base du réseau Sigfox.

Les caractéristiques du réseau Sigfox et du signal de balise « Monarch » sont bien connues de l'homme du métier.

Celui-ci pourra par exemple se référer à toutes fins utiles au document intitulé «Monarch physical interface description and hardware device requirements », rev. 1.2, daté du 2 août 2018 et disponible sur internet avec le lien suivant :
https://www.disk91.com/wp-content/uploads/2019/09/Monarch_physical_interface_description_and _device_HW_requirements_v1.2_external.pdf

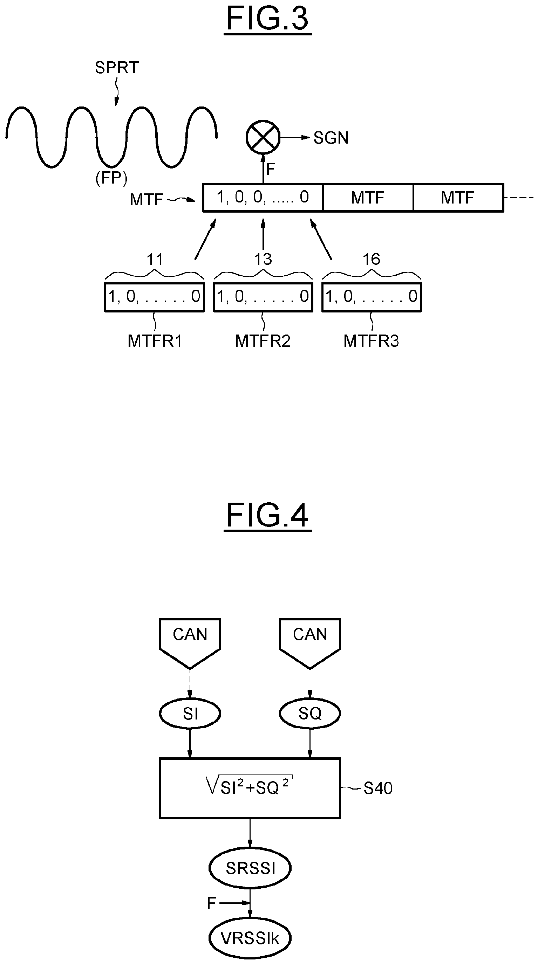

Comme illustré sur la figure 3, ledit motif MTF appartient dans cet exemple à un groupe de J motifs de référence, ici 3 motifs de référence MTFR1, MTFR2, MTFR3.

Le motif MTFR1 comporte 11 échantillons.

Le motif MTFR2 comporte 13 échantillons.

Le motif MTFR3 comporte 16 échantillons.

Les 3 entiers 11, 13 et 16 sont premiers entre eux.

Le motif MTF peut donc être l'un de ces motifs de référence et comporte donc 11, 13 ou 16 échantillons séquencés à une fréquence F, par exemple 16384Hz.

Le signal SGN est issu d'une porteuse SPRT, ici une porteuse sinusoïdale, ayant une fréquence porteuse FP modulée par les N échantillons motif numérique MTF par une modulation en tout ou rien (modulation OOK) à la fréquence de modulation F (ici 16384Hz) pendant une durée de modulation au cours de laquelle le motif se répète à une fréquence égale à F/N.

Parmi les Nj échantillons de chaque motif de référence MTFRj (j=1 à 3), un seul échantillon logique (ici un bit égal à 1) autorise l'émission de la porteuse, les Nj-1 (10, 12 ou 15) autres échantillons logiques (ici des bits nuls) inhibant l'émission de ladite porteuse.

Si l'on se réfère de nouveau à la figure 1, on voit que le dispositif DIS comprend une interface d'entrée, ici une antenne ANT, configurée pour recevoir le signal SGN et des moyens de traitement MT.

Ces moyens de traitement comportent notamment au sein d'une chaîne de réception CHR, connectée à l'antenne par un duplexeur DX, des moyens de transposition MTR de structure classique et connue en soi, configurés pour effectuer une transposition du signal reçu I et QSGN en bande de base sur deux voies en quadrature de phase à l'aide de la fréquence porteuse FP.

A cet égard un oscillateur OSC délivre le signal de transposition à la fréquence FP à deux mélangeurs (l'un des signaux de transposition étant déphasé de 90°).

Les moyens de traitement comportent également de préférence des moyens de filtrage configurés pour effectuer un filtrage canal de la bande de fréquences supérieures à la fréquence F (ici 16384Hz).

Les moyens de traitement comportent également un étage de conversion CAN configuré pour effectuer une conversion analogique numérique des deux signaux en quadrature de phase filtrés de façon à obtenir deux signaux numériques en bande de base SI et SQ.

Un processeur PROC est configuré pour effectuer des traitements en bande de base.

Ce processeur PROC incorpore au moins de façon logicielle par exemple, une partie des moyens de traitement.

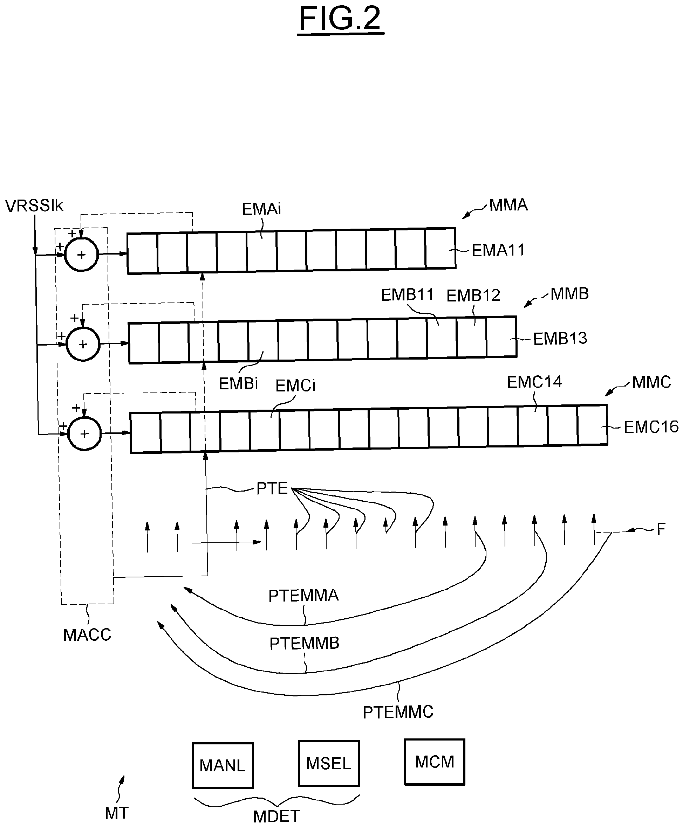

Comme illustré sur la figure 2, le dispositif comporte autant de moyens de mémoire qu'il y a de motifs de référence.

Le dispositif comporte donc ici 3 (J=3) moyens de mémoire MMA, MMB et MMC ayant respectivement Nj emplacements-mémoire.

Le moyen de mémoire MMA comporte 11 emplacements-mémoire EMAi (i=1 à 11). Il est associé au motif de référence MTFR1.

Le moyen de mémoire MMB comporte 13 emplacements-mémoire EMBi (i=1 à 13). Il est associé au motif de référence MTFR2.

Le moyen de mémoire MMC comporte 16 emplacements-mémoire EMCi (i=1 à 16). Il est associé au motif de référence MTFR3.

Les moyens de traitement MT comportent également des moyens d'accumulation MACC configurés pour effectuer à la fréquence F et pendant une durée d'acquisition, par exemple 19 ms, des adressages successifs et de façon circulaire des emplacements-mémoire des J moyens de mémoire, et des stockages accumulatifs successifs de valeurs VRSSIk indicatives de l'intensité du signal SGN, en parallèle dans les J emplacements mémoires adressés des J moyens de mémoire.

Plus précisément, comme illustré sur la figure 4, on détermine à partir desdits signaux numériques en bande de base SI et SQ, par exemple en effectuant (étape S40) des racines carrées des sommes des des valeurs au carré des échantillons des signaux numériques SI et SQ, un signal SRSSI, d'où l'on extrait à la fréquence de modulation F (ici 16384Hz), les valeurs VRSSIk indicatives de l'intensité du signal SGN.

Cette détermination des valeurs VRSSIk est effectuée par des moyens d'analyse MANL (figure 2) incorporés dans le processeur PROC et faisant partie de moyens MDET de détection de la présence éventuelle d'un motif dans le signal SGN.

Comme illustré sur la figure 2, chaque valeur VRSSIk est stockée en parallèle dans les 3 moyens de mémoire MMA, MMB et MMC dans les emplacements-mémoire adressés par exemple par un pointeur d'écriture PTEMMA, PTEMMB, PTEMMC associé à chaque moyen de mémoire.

Et la valeur courante VRSSIk stockée dans un emplacement-mémoire est accumulée avec le contenu de cet emplacement-mémoire résultant des stockages précédents.

Chaque pointeur PTE se déplace à la fréquence F pour adresser tous les emplacements-mémoire des moyens de mémoire.

Et après que le pointeur d'écriture a pointé sur le dernier emplacement-mémoire d'un moyen de mémoire, il va pointer au coup suivant sur le premier emplacement-mémoire de ce moyen de mémoire.

C'est le cas pour le pointeur PTEMMB lorsque le 11^{ème} emplacement-mémoire EMA11 du moyen de mémoire MMA a été adressé.

C'est le cas pour le pointeur PTEMMB lorsque le 13^{ème} emplacement-mémoire EMB13 du moyen de mémoire MMB a été adressé.

C'est le cas pour le pointeur PTEMMC lorsque le 16^{ème} emplacement-mémoire EMC16 du moyen de mémoire MMC a été adressé.

Matériellement ces moyens de mémoire peuvent être de toute structure connue, par exemple des mémoires tampons (« buffer ») circulaires.

Afin d'effectuer une détection de la présence éventuelle dudit d'un motif dans le signal reçu SGN, les moyens d'analyse MANL sont configurés pour effectuer une analyse des valeurs cumulées contenues dans les emplacements mémoire des J moyens de mémoire.

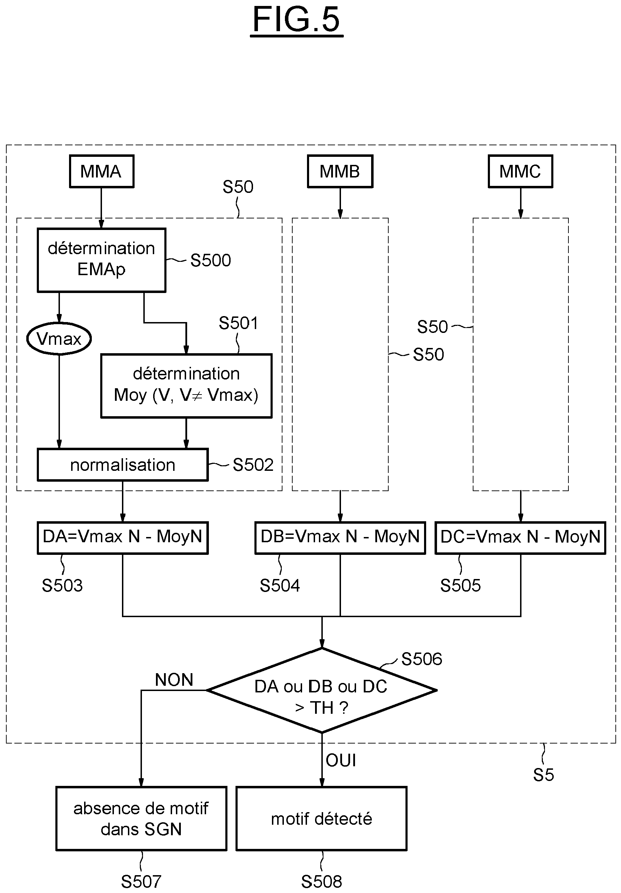

Un exemple de cette analyse est décrit plus particulièrement en référence à la figure 5.

Il convient à cet égard de noter que lorsqu'un motif correspondant à l'un des motifs de référence, est présent dans le signal SGN, la valeur VRSSI correspondant à la modulation de la porteuse par le bit du motif égal à 1, va lors de la durée d'acquisition toujours se cumuler dans le même emplacement-mémoire du moyen de mémoire associé à ce motif de référence.

Par contre cette valeur VRSSI va être accumulée de façon uniforme sur tous les emplacements-mémoire des autres moyens de mémoire, en raison du caractère mutuellement premier des nombres d'emplacements-mémoires, ici 11, 13 et 16, des moyens de mémoire.

A cet égard on choisira de préférence une durée d'acquisition au moins 10 fois plus grande que la durée du motif ayant le plus grand nombre d'échantillons.

Comme illustré sur la figure 5, après la durée d'acquisition, les moyens d'analyse sont configurés pour effectuer le groupe d'opérations S50 pour chacun des moyens de mémoire.

Ceci va être décrit maintenant plus particulièrement pour le moyen de mémoire MMA.

Plus précisément, les moyens d'analyse déterminent (S500) l'emplacement-mémoire EMAp dont la valeur cumulée Vmax est la plus grande.

Ils effectuent aussi une détermination S501 d'une moyenne des valeurs cumulées contenues dans les autres emplacements-mémoire.

Puis une normalisation S502 est effectuée.

Plus précisément la valeur Vmax est (par exemple divisée) par le nombre de fois où le moyen de mémoire correspondant, ici le moyen de mémoire MMA, a été totalement adressé durant la durée d'acquisition, de façon à obtenir la valeur normalisée VmaxN.

De même la moyenne obtenue à l'étape S501 est normalisée (par exemple divisée) par le nombre de fois où le moyen de mémoire correspondant, ici le moyen de mémoire MMA, a été totalement adressé, de façon à obtenir la moyenne normalisée MoyN.

Puis les moyens d'analyse calculent (étape 503) une différence DA entre la valeur normalisée VmaxN et la moyenne normalisée MoyN.

Les moyens d'analyse déterminent également les différences DB et DC pour les deux autres moyens de mémoire MMB et MMC.

Les moyens d'analyse comparent ensuite ces différences à un seuil TH (étape S506).

Et une obtention de chacune des différences inférieures au seuil TH est représentative de l'absence de tout motif dans le signal (S507)

En d'autres termes, si toutes les différences sont inférieures au seuil TH, on peut en conclure une absence de tout motif dans le signal.

Par contre une obtention de l'une des J différences supérieure au seuil correspondant est représentative de la présence dans le signal du motif ayant le nombre d'échantillons égal au nombre d'emplacements mémoire du moyen de mémoire pour lequel ladite différence supérieure au seuil a été obtenue (étape S508).

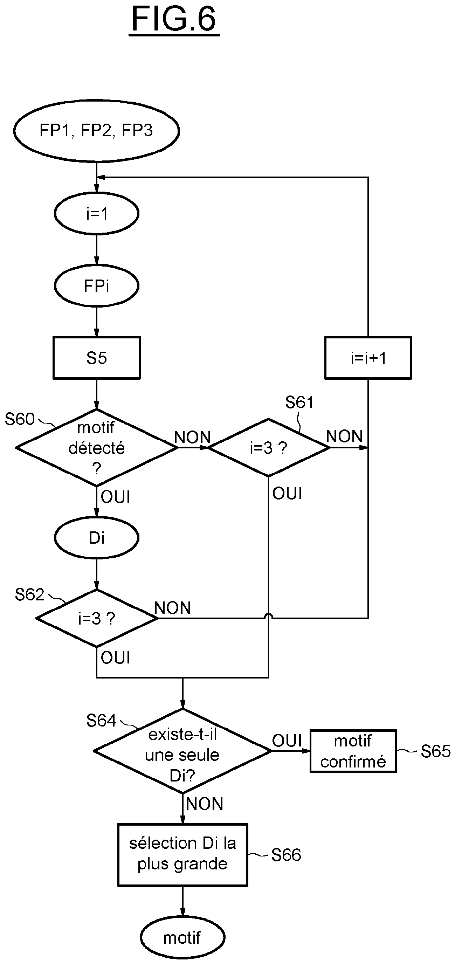

Il est par ailleurs possible, comme c'est le cas par exemple pour le signal de balise « Monarch » que, comme illustré sur la figure 6, que la fréquence porteuse appartienne à un ensemble de fréquences différentes, ici trois fréquences FP1, FP2, FP3.

Il est alors prévu que le dispositif comprenne des moyens de commande MCM (figure 2), par exemple réalisés de façon logicielle au sein du processeur PROC, et configurés pour activer les moyens de traitement pour chacune des fréquences différentes de façon à détecter la présence dudit au moins un motif et la fréquence de la porteuse.

Plus précisément, comme illustré sur la figure 6, pour chaque fréquence porteuse possible FPi, les moyens de traitement effectuent l'ensemble des opérations désignées sur la figure 5 par la référence globale S5.

Si pour la fréquence porteuse FPi aucun motif n'est détecté et que l'on n'a pas parcouru toutes les fréquences porteuses possibles (S60 et S61) alors on recommence l'ensemble des opérations S5 pour les autres fréquences porteuses possibles.

Si dans l'étape S60, un motif a potentiellement été détecté pour une fréquence porteuse FPi, par obtention d'une différence Di supérieure au seuil TH, mais que toutes les fréquences porteuses possibles n'ont pas été explorées (étape d'interrogation S62 et réponse NON), alors on recommence l'ensemble des opérations S5 pour les autres fréquences porteuses possibles de façon soit à confirmer la détection précédente soit pour affiner cette détection comme il sera expliqué ci-après.

Les moyens d'analyse testent ensuite dans l'étape S64, la présence d'une ou de plusieurs différences obtenues supérieures au seuil.

Si une seule différence Di supérieure au seuil a été obtenue pour la fréquence FPi, alors le motif détecté est confirmé (étape S65) et la fréquence porteuse est bien la fréquence FPi.

Cela étant, il est possible en particulier lorsque des fréquences porteuses sont proches l'une de l'autre que l'on obtienne plusieurs différences Di supérieures au seuil pour différentes fréquences porteuses FPi.

Dans ce cas, des moyens de sélection MSEL, faisant partie des moyens de détection MDET (figure 2) sélectionnent la plus grande différence (S66) pour désigner le motif et la fréquence porteuse correspondante.

Il est possible que le signal SGN comporte successivement plusieurs motifs.

C'est le cas par exemple pour le signal de balise « Monarch » le signal balise du réseau Sigfox, qui a une longueur de 400 ms et qui contient un premier motif de 362 ms suivi d'un deuxième motif de 32 ms. Ce signal de balise est émis à un instant temporellement aléatoire au cours d'une fenêtre de 10 secondes se répétant toutes les cinq minutes.

Chacun de ces deux motifs peut être l'un des trois motifs de référence MTFR1, MTFR2, MTFR3.

Par ailleurs, plusieurs fréquences porteuses ou fréquences centrales FP sont possibles pour ce signal de balise.

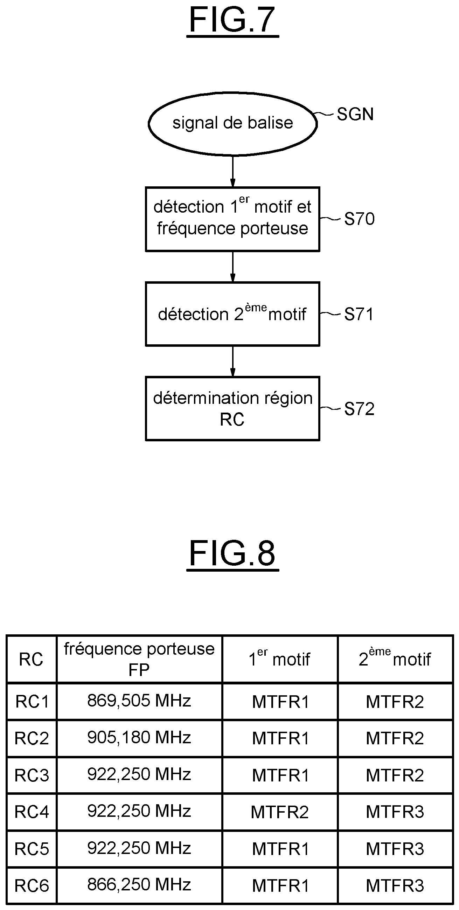

On peut alors définir par exemple, comme illustré dans le tableau de la figure 8 et extrait du document précité, 6 configurations radio ou régions RC1-RC6, chacune étant définie par une fréquence centrale et une combinaison d'un premier motif et d'un deuxième motif.

Ainsi, comme illustré sur la figure 7, lorsque le signal SGN, par exemple le signal de balise « Monarch » comporte plusieurs motifs à détecter, par exemple deux motifs, les moyens de commande MCM activent les moyens de traitement pour détecter le premier motif et la fréquence porteuse (étape S70) puis activent les moyens de traitement pour détecter le deuxième motif (étape S71) en utilisant la fréquence porteuse trouvée.

Les moyens de traitement déterminent ainsi la région RCi correspondante (étape S72).

Une fois cette région de configuration déterminée, le reste du dialogue entre la station de base et l'objet connecté s'effectue de façon classique par une modulation/démodulation du type GFSK dans le sens station de base vers objet et par une modulation/démodulation du type FSK dans le sens objet vers station de base, en utilisant au sein de l'objet, la chaîne d'émission CTR avec étage analogique numérique DAC et transposition montante (figure 1).

## Revendications

1. Procédé de détection de la présence éventuelle d'au moins un motif numérique au sein d'un signal, ledit au moins un motif (MTF) appartenant à un groupe de J motifs de référence (MTFR1-MTFR3), J étant supérieur ou égal à 2, comportant respectivement Nj échantillons séquencés à une fréquence F, Nj étant un entier différent pour chaque motif de référence, et les J entiers Nj étant premiers entre eux, ledit signal (SGN) étant issu d'une porteuse modulée par les Nj échantillons dudit au moins un motif numérique par une modulation en tout ou rien à la fréquence F pendant une durée de modulation au cours de laquelle le motif se répète à une fréquence égale à F/Nj, chaque motif de référence ayant un seul échantillon autorisant l'émission de la porteuse et Nj-1 échantillons logiques inhibant l'émission de ladite porteuse, procédé comprenant une réception du signal (SGN) et un traitement du signal reçu comprenant :
a) à la fréquence F et pendant une durée d'acquisition,
des adressages successifs et de façon circulaire des emplacements-mémoire de J moyens de mémoire (MMA, MMB, MMC) ayant respectivement Nj emplacements-mémoire, et
des stockages accumulatifs successifs de valeurs indicatives de l'intensité du signal (VRSSIk), en parallèle dans les J emplacements mémoires adressés des J moyens de mémoire, et
b) une détection de la présence éventuelle dudit au moins un motif comportant une analyse (MANL) des valeurs cumulées contenues dans les emplacements mémoire des J moyens de mémoire.

2. Procédé selon la revendication 1, dans lequel ladite analyse comporte pour chacun des J moyens de mémoire (MMA, MMB, MMC), une détermination de l'emplacement-mémoire dont la valeur cumulée est la plus grande, une détermination d'une moyenne des valeurs cumulées contenues dans les autres emplacements-mémoire, une différence (Di) entre une valeur tirée de ladite valeur cumulée la plus grande et ladite moyenne, et une comparaison de ladite différence à un seuil.

3. Procédé selon la revendication 2, dans lequel ladite valeur (VmaxN) est la valeur cumulée la plus grande normalisée par le nombre de fois où le moyen de mémoire correspondant a été totalement adressé, et ladite moyenne (MoyN) est la moyenne desdites valeurs cumulées contenues dans les autres emplacements-mémoire, normalisée par le nombre de fois où le moyen de mémoire correspondant a été totalement adressé.

4. Procédé selon la revendication 2 ou 3, dans lequel une obtention de chacune des J différences (Di) inférieure au seuil correspondant, est représentative de l'absence de tout motif dans le signal.

5. Procédé selon la revendication 2, 3 ou 4, dans lequel une obtention de l'une des J différences (Di) supérieure au seuil correspondant est représentative de la présence dans le signal du motif ayant le nombre d'échantillons égal au nombre d'emplacements mémoire du moyen de mémoire pour lequel ladite différence supérieure au seuil a été obtenue.

6. Procédé selon l'une des revendications précédentes, dans lequel la durée d'acquisition est au moins 10 fois plus grande que la durée du motif de référence (MTFR3) ayant le plus grand nombre d'échantillons.

7. Procédé selon l'une des revendications précédentes, dans lequel la porteuse est un signal périodique ayant une fréquence porteuse (FP), ledit traitement comprend en outre préalablement aux étapes a) et b),
c) une transposition du signal reçu en bande de base sur deux voies en quadrature de phase (I, Q) à l'aide de la fréquence porteuse, et
d) une conversion analogique numérique (CAN) des deux signaux en quadrature de phase de façon à obtenir deux signaux numériques en bande de base (SI, SQ), et
l'étape a) comprend une détermination desdites valeurs indicatives de l'intensité du signal (VRSSIk) à partir desdits signaux numériques en bande de base.

8. Procédé selon l'une des revendications précédentes, dans lequel ledit signal (SGN) est issu de la porteuse modulée par une modulation en tout ou rien par un premier motif numérique appartenant au groupe de J motifs de référence pendant une première durée de modulation puis par un deuxième motif numérique appartenant au groupe de J motifs de référence pendant une deuxième durée de modulation, et dans lequel après avoir détecté la présence du premier motif, on met en œuvre ledit traitement pour détecter la présence éventuelle du deuxième motif.

9. Procédé selon la revendication 7, dans lequel la fréquence porteuse appartient à un ensemble de fréquences différentes (FP1, FP2, FP3), et le traitement comporte une mise en œuvre des étapes a), b), c) et d) pour chacune des fréquences différentes de façon à détecter la présence dudit au moins un motif et la fréquence de la porteuse.

10. Procédé selon la revendication 9, dans lequel en cas d'obtention plusieurs différences supérieures aux seuils correspondants, on sélectionne (S66) la plus grande pour désigner ledit au moins un motif.

11. Procédé selon la revendication 8 et l'une des revendications 9 ou 10, dans lequel après avoir détecté (S70) la présence du premier motif et la fréquence de la porteuse, le traitement de la détection (S71) de la présence éventuelle du deuxième motif comprend la mise en œuvre de l'étape c) avec la fréquence de la porteuse déterminée lors de la détection du premier motif.

12. Procédé selon l'une des revendications précédentes, dans lequel J est égal à 3 et les trois entiers Nj sont respectivement égaux à 11, 13 et 16.

13. Procédé selon l'une des revendications précédentes, dans lequel ledit signal (SGN) est un signal de balise utilisé dans le réseau d'objets connectés Sigfox.

14. Dispositif de détection de la présence éventuelle d'au moins un motif numérique au sein d'un signal, ledit au moins un motif appartenant à un groupe de J motifs de référence (MTFR1, MTFR2, MTFR3), J étant supérieur ou égal à 2, comportant respectivement Nj échantillons séquencés à une fréquence F, Nj étant un entier différent pour chaque motif de référence, et les J entiers Nj étant premiers entre eux, ledit signal étant issu d'une porteuse modulée par les Nj échantillons dudit au moins un motif numérique par une modulation en tout ou rien à la fréquence F pendant une durée de modulation au cours de laquelle le motif se répète à une fréquence égale à F/Nj, chaque motif de référence ayant un seul échantillon autorisant l'émission de la porteuse et Nj-1 échantillons logiques inhibant l'émission de ladite porteuse, dispositif comprenant une interface d'entrée (ANT) configurée pour recevoir le signal, J moyens de mémoire (MMA, MMB, MMC) ayant respectivement Nj emplacements-mémoire, et des moyens de traitement (MT) comportant :
- des moyens d'accumulation configurés pour effectuer à la fréquence F et pendant une durée d'acquisition, des adressages successifs et de façon circulaire des emplacements-mémoire des J moyens de mémoire, et des stockages accumulatifs successifs de valeurs indicatives de l'intensité du signal, en parallèle dans les J emplacements mémoires adressés des J moyens de mémoire, et
- des moyens de détection configurés pour effectuer une détection de la présence éventuelle dudit au moins un motif et comportant des moyens d'analyse (MANL) configurés pour effectuer une analyse des valeurs cumulées contenues dans les emplacements mémoire des J moyens de mémoire.

15. Dispositif selon la revendication 14, dans lequel les moyens d'analyse (MANL) sont configurés pour effectuer, pour chacun des J moyens de mémoire, une détermination de l'emplacement-mémoire dont la valeur cumulée est la plus grande, une détermination d'une moyenne des valeurs cumulées contenues dans les autres emplacements-mémoire, une différence (Di) entre une valeur tirée de ladite valeur cumulée la plus grande et ladite moyenne, et une comparaison de ladite différence à un seuil.

16. Dispositif selon la revendication 15, dans lequel ladite valeur (VmaxN) est la valeur cumulée la plus grande normalisée par le nombre de fois où le moyen de mémoire correspondant a été totalement adressé, et ladite moyenne (MoyN) est la moyenne desdites valeurs cumulées contenues dans les autres emplacements-mémoire, normalisée par le nombre de fois où le moyen de mémoire correspondant a été totalement adressé.

17. Dispositif selon la revendication 15 ou 16, dans lequel une obtention de chacune des J différences (Di) inférieure au seuil correspondant, est représentative de l'absence de tout motif dans le signal.

18. Dispositif selon la revendication 15, 16 ou 17, dans lequel une obtention de l'une des J différences (Di) supérieure au seuil correspondant est représentative de la présence dans le signal du motif ayant le nombre d'échantillons égal au nombre d'emplacements mémoire du moyen de mémoire pour lequel ladite différence supérieure au seuil a été obtenue.

19. Dispositif selon l'une des revendications 14 à 18, dans lequel la durée d'acquisition est au moins 10 fois plus grande que la durée du motif de référence (MTFR3) ayant le plus grand nombre d'échantillons.

20. Dispositif selon l'une des revendications 14 à 19, dans lequel la porteuse est un signal périodique ayant une fréquence porteuse, les moyens de traitement comprennent
- des moyens de transposition (MTR) configurés pour effectuer une transposition du signal reçu en bande de base sur deux voies en quadrature de phase à l'aide de la fréquence porteuse, et
- un étage de conversion (CAN) configuré pour effectuer une conversion analogique numérique des deux signaux en quadrature de phase de façon à obtenir deux signaux numériques en bande de base, et
les moyens d'analyse sont configurés pour effectuer une détermination desdites valeurs indicatives de l'intensité du signal à partir desdits signaux numériques en bande de base.

21. Dispositif selon l'une des revendications 14 à 20, dans lequel ledit signal est issu de la porteuse modulée par une modulation en tout ou rien par un premier motif numérique appartenant au groupe de J motifs de référence pendant une première durée de modulation puis par un deuxième motif numérique appartenant au groupe de J motifs de référence pendant une deuxième durée de modulation, et dans lequel le dispositif comprend en outre des moyens de commande MCM) configurés pour, après détection de la présence du premier motif, activer les moyens de traitement (MT) pour détecter la présence éventuelle du deuxième motif.

22. Dispositif selon la revendication 20, dans lequel la fréquence porteuse appartient à un ensemble de fréquences différentes, et les moyens de commande (MCM) sont configurés pour activer les moyens de traitement pour chacune des fréquences différentes de façon à détecter la présence dudit au moins un motif et la fréquence de la porteuse.

23. Dispositif selon la revendication 22, dans lequel en cas d'obtention de plusieurs différences (Di) supérieures aux seuils correspondants, les moyens de détection comprennent des moyens de sélection (MSEL) sont configurés pour sélectionner la plus grande pour désigner ledit au moins un motif.

24. Dispositif selon la revendication 21 et l'une des revendications 22 ou 23, dans lequel après avoir détecté la présence du premier motif et la fréquence de la porteuse, les moyens de commande (MCM) sont configurés pour activer les moyens de traitement pour ladite fréquence porteuse de façon à détecter la présence éventuelle du deuxième motif.

25. Dispositif selon l'une des revendications 14 à 24, dans lequel J est égal à 3 et les trois entiers Nj sont respectivement égaux à 11, 13 et 16.

26. Dispositif selon l'une des revendications 14 à 25, dans lequel ledit signal (SGN) est un signal de balise utilisé dans le réseau d'objets connectés Sigfox.

27. Objet connecté incorporant un dispositif (DIS) selon l'une des revendications 14 à 26.
